(19) Europäisches Patentamt
European Patent Office
Office européen des brevets

(11) **EP 3 559 767 B1**

(12) **FASCICULE DE BREVET EUROPEEN**

(45) Date de publication et mention de la délivrance du brevet:
**13.05.2020 Bulletin 2020/20**

(21) Numéro de dépôt: **17822004.2**

(22) Date de dépôt: **14.12.2017**

(51) Int Cl.:
*G05B 23/02* (2006.01)   *G21D 3/00* (2006.01)
*G06F 11/00* (2006.01)

(86) Numéro de dépôt international:
**PCT/FR2017/053577**

(87) Numéro de publication internationale:
**WO 2018/115646 (28.06.2018 Gazette 2018/26)**

(54) **PROCÉDÉ DE CARACTÉRISATION D'UNE OU PLUSIEURS DÉFAILLANCES D'UN SYSTÈME**

VERFAHREN ZUR FEHLERCHARAKTERISIERUNG IN EINEM SYSTEM

METHOD FOR CHARACTERIZING ONE OR MORE FAULTS IN A SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2016 FR 1663261**

(43) Date de publication de la demande:
**30.10.2019 Bulletin 2019/44**

(73) Titulaires:
• **Electricité de France**
  **75008 Paris (FR)**
• **Metroscope**
  **92300 Levallois Perret (FR)**

(72) Inventeurs:
• **SCHWARTZ, Aurélien**
  **25220 Thise (FR)**
• **PINEAU, David**
  **44120 Vertou (FR)**

(74) Mandataire: **Regimbeau**
  **20, rue de Chazelles**
  **75847 Paris Cedex 17 (FR)**

(56) Documents cités:
EP-A2- 1 677 172      EP-A2- 2 642 362
US-A1- 2002 066 054   US-A1- 2004 002 776

Remarques:
Le dossier contient des informations techniques présentées postérieurement au dépôt de la demande et ne figurant pas dans le présent fascicule.

**Description**

DOMAINE TECHNIQUE GENERAL ET CONTEXTE DE L'INVENTION

La présente invention concerne le domaine de la commande et de la surveillance d'un système physique. Plus précisément, l'invention se rapporte à la caractérisation d'une ou plusieurs défaillances d'un système complexe industriel.

Tout système peut présenter des défaillances, c'est-à-dire des modifications non désirées de certaines de ses grandeurs physiques représentatives du fonctionnement, qui peuvent être dues à de nombreux facteurs (vieillissement d'un composant, dysfonctionnement d'un composant, etc.). Ces défaillances peuvent prendre diverses formes, en fonction de leur nature et du composant concerné, et se traduire différemment dans les grandeurs physiques représentatives du fonctionnement du système. Néanmoins, une défaillance d'un système compromet le fonctionnement du système, qui présente alors un fonctionnement dégradé par rapport au fonctionnement du système en l'absence de défaillance, ce qu'on appelle le système sain.

La performance d'un système industriel et son maintien dans le temps constituent un enjeu majeur pour toute industrie. La limitation du nombre et de la durée des arrêts pour maintenance, ainsi que l'optimisation du rendement sont des sources importantes de gains d'exploitation. L'optimisation du rendement d'un système industriel passe en particulier par la détection, la localisation et la quantification, avec la meilleure précision possible, de l'impact des différentes dégradations. Ces informations permettent de déclencher les actions de maintenance adéquates et peuvent, à terme, être utilisées pour définir une stratégie de maintenance préventive efficace.

Tout système industriel important est équipé de capteurs qui ont pour mission de surveiller les valeurs prises par les grandeurs physiques représentatives du fonctionnement du système. Un problème est détecté lorsqu'une mesure issue d'un capteur s'écarte d'une valeur normalement admise, qui indiquerait une dégradation de la performance d'un composant ou processus interne au système. Toutefois, une telle détection ne renseigne pas sur la nature de la défaillance du système, mais permet uniquement d'en détecter un symptôme. Par ailleurs, le système peut présenter une défaillance qui bien qu'affectant une ou plusieurs valeurs mesurées, n'entraîne pas de modification suffisante de ces valeurs mesurées pour être détectée, d'autant plus que les valeurs des grandeurs physiques varient en fonction du pilotage et des grandeurs physiques extérieures au système.

Il revient alors à un opérateur d'analyser les mesures pour tenter de caractériser la défaillance du système, en mettant en oeuvre différents outils tels que des arbres décisionnels, des modèles numériques de simulation, ou bien encore des outils basés sur des méthodes d'apprentissage statistique, et surtout en se reposant sur son expérience personnelle du comportement du système, ou l'expérience consignée par d'autres dans ces outils.

La détection et la caractérisation d'une défaillance repose ainsi sur le maniement d'informations très nombreuses et de natures variées (mesures, connaissances métiers, incertitudes, modélisation) et sur des interactions complexes. La réalisation de tels diagnostics nécessite, pour les cas non triviaux, le recours systématique aux services experts, et souffre de n'avoir aucune méthode à même d'intégrer les problèmes rencontrés dans toute leur complexité. En outre, le temps nécessaire pour mener ces opérations retarde d'autant la mise en oeuvre des actions requises pour corriger la défaillance.

Il a été mis au point des procédés de surveillance utilisant des algorithmes d'apprentissage de surveillance électronique ("e-monitoring"). Ces algorithmes d'apprentissage cherchent à caractériser le comportement du système en utilisant un historique de données de surveillance du système, dans un mode sans défaillances, et en présence de défaillances connues. L'algorithme d'apprentissage utilise les valeurs mesurées par les capteurs, et les compare aux données de la base d'apprentissage.

Par exemple, le document EP 1 677 172 A2 décrit un procédé de surveillance et de détection de défauts dans un moteur d'aéronef, dans lequel des résidus sont calculés, correspondants aux différences entre des signaux détectés et des estimations basées sur un filtre de Kalman étendu. Puis, à partir d'un test d'hypothèse bayésien, la probabilité d'appartenance à l'un des types de défaillance connues est déterminé en partant des résidus, le niveau de corrélation permettant enfin d'obtenir la sévérité de l'erreur détectée.

Toutefois, un procédé basé sur l'apprentissage est difficilement applicable aux systèmes complexes car il est incapable d'explorer empiriquement toutes les conditions nominales de fonctionnement du système, d'autant plus que ces procédés diagnostiques sont souvent limités dans le nombre de capteurs qu'ils peuvent embarquer. De plus il est presque impossible de garantir que la période d'apprentissage supervisée d'un tel procédé corresponde bien au fonctionnement nominal de l'installation. Les retours d'expérience de l'utilisation de ces procédés témoignent de la génération importante de fausses alarmes liées aux limites de l'apprentissage, c'est-à-dire par des erreurs de caractérisation des domaines de fonctionnement nominal et des défaillances.

Or, la caractérisation des défaillances intervenant dans un système est d'autant plus importante qu'elle conditionne les actions à entreprendre pour corriger ces défaillances. Un manque de certitude sur la caractérisation de la défaillance peut empêcher l'accomplissement des actions appropriées qui pourraient permettre de remédier à la défaillance, et donc de regagner les pertes de productions ou empêcher une aggravation de l'état du composant affecté.

En outre, l'algorithme d'apprentissage nécessite des réapprentissages réguliers et complets du comportement du système pour en enrichir la connaissance dans des conditions de fonctionnement particulières ou pallier des problématiques métrologiques (réétalonnages de capteurs). La maintenance et la mise à jour d'un tel algorithme se révèlent donc particulièrement lourdes.

De plus, l'algorithme d'apprentissage ne peut détecter et identifier que des dégradations de fonctionnement déjà rencontrées, identifiées par un opérateur, et implémentées dans l'algorithme.

En outre, de tels procédés basés sur un algorithme d'apprentissage requièrent que le système soit déjà physiquement installé et nécessitent de disposer d'une base de données d'historiques de mesures. La conséquence directe est que ces outils de diagnostic ne peuvent être mis en oeuvre dès la réception d'un nouveau système industriel.

PRESENTATION DE L'INVENTION

L'invention ci-après présente un procédé de caractérisation d'une ou plusieurs défaillances d'un système, qui exploite la connaissance du comportement nominal du système quelles que soient les conditions aux limites de celui-ci, et sans limite de dimension, et qui permet d'identifier et de caractériser de façon fine les défaillances survenant dans un système.

L'invention propose à cet effet un procédé de caractérisation d'une ou plusieurs défaillances d'un système regroupant une pluralité de grandeurs physiques internes et délimité par une pluralité de grandeurs physiques aux limites, le système étant modélisé par un modèle sain établissant des relations liant entres elles lesdites grandeurs physiques internes et avec les grandeurs physiques aux limites en l'absence de défaillance, une défaillance se définissant comme une altération des relations liant lesdites grandeurs physiques internes entre elles et avec les grandeurs physiques aux limites par rapport au modèle sain,

ledit système étant muni d'une pluralité de capteurs mesurant des valeurs de grandeurs physiques internes et les grandeurs physiques externes,

le procédé comprenant la mise en oeuvre d'étapes de :

- construction d'un vecteur des mesures mesurées d'un ensemble de grandeurs physiques internes en relevant des valeurs de grandeurs physiques internes mesurées par les capteurs,
- détermination d'un vecteur des symptômes réels par la différence entre le vecteur des mesures mesurées et un vecteur de mesures simulées, ledit vecteur de mesures simulées regroupant des valeurs de grandeurs physiques internes obtenues par simulation du modèle sain à partir des grandeurs physiques aux limites,
- et, pour un nombre déterminé d'itérations :

  ◦ détermination d'un vecteur des défaillances proposé à partir d'un vecteur des défaillances courant par un tirage pseudo-aléatoire utilisant une loi de probabilité sur chacune des valeurs de défaillance du vecteur des défaillances courant, un vecteur des défaillances regroupant des valeurs représentatives d'une ou plusieurs défaillances ;
  ◦ détermination de la probabilité d'acceptation du vecteur des défaillances proposé en utilisant le vecteur des symptômes réels, une matrice des défaillances, le vecteur des défaillances courant, la distribution probabiliste du vecteur des symptômes réels sachant le vecteur des défaillances courant, le vecteur des défaillances proposé, la distribution probabiliste du vecteur des symptômes réels sachant le vecteur des défaillances proposé, et une distribution de probabilité a priori de survenues des valeurs du vecteur des défaillances, ladite matrice des défaillances regroupant les conséquences de chaque défaillance sur les grandeurs physiques internes ;
  ◦ remplacement ou non du vecteur des défaillances courant par le vecteur des défaillances proposé en fonction de la probabilité d'acceptation du vecteur des défaillances proposé,

- caractérisation d'une défaillance en comptabilisant le nombre d'itérations ayant fait intervenir ladite défaillance.

L'invention est avantageusement complétée par les différentes caractéristiques suivantes prises seules ou selon leurs différentes combinaisons possibles :

- la détermination de la probabilité d'acceptation du vecteur des défaillances proposé utilise un vecteur des symptômes proposé et un vecteur des symptômes courant, le vecteur des symptômes courant étant déterminé à partir du vecteur des défaillances courant en utilisant la matrice des défaillances, et le vecteur des symptômes proposé étant déterminé à partir du vecteur des défaillances proposé en utilisant la matrice des défaillances ;
- chaque colonne de la matrice des défaillances correspond à un vecteur signature d'au moins une défaillance représentatif de l'impact de ladite défaillance sur des grandeurs physiques internes mesurées par des capteurs, et le nombre de lignes de la matrice est déterminé par le nombre de grandeurs physiques internes mesurées prises en compte et le nombre de colonnes de la matrice est déterminé par le nombre des défaillances prises en compte ;

- le procédé comprend une étape préalable de détermination de la matrice des défaillances, dans laquelle on détermine pour chaque défaillance :

  - un premier vecteur de mesures simulées par simulation du modèle sain à partir des grandeurs physiques aux limites ;
  - un second vecteur de mesures simulées par simulation du modèle sain en altérant des relations du modèle sain en fonction de la défaillance avec les mêmes grandeurs physiques aux limites ;
    le vecteur signature de la défaillance correspondant à la différence entre le second vecteur et le premier vecteur ;

- un ensemble de défaillances affectant le système sont préalablement connues et renseignées dans un vecteur des défaillances connues, et lors des itérations, le vecteur des défaillances courant est complété par le vecteur des défaillances connues ;
- le vecteur des symptômes courant est déterminé à partir de la matrice des défaillances, du vecteur des défaillances courant et du vecteur des défaillances connues, et le vecteur des symptômes proposé est déterminé à partir de la matrice des défaillances, du vecteur des défaillances proposé et du vecteur des défaillances connues ;
- la caractérisation d'une défaillance comprend la détermination de la probabilité de la présence de la défaillance dans le système et/ou la détermination d'une valeur de cette défaillance ;
- la probabilité d'acceptation du vecteur des défaillances proposé est déterminée en comparant la densité de la loi jointe au point du vecteur des défaillances proposé avec la densité de la loi jointe au point du vecteur des défaillances courant, les densités de la loi jointe aux points susmentionnés étant déterminées par le vecteur des symptômes réels observés, la matrice des défaillances, le vecteur des défaillances proposé, le vecteur des défaillances courant, la distribution probabiliste du vecteur des symptômes sachant le vecteur des défaillances courant, la distribution probabiliste du vecteur des symptômes sachant le vecteur des défaillances proposé, et la distribution de probabilité apriori de survenues des valeurs du vecteur des défaillances.

L'invention concerne aussi un produit programme d'ordinateur comprenant des instructions de code de programme pour l'exécution des étapes du procédé selon l'invention, lorsque ledit programme est exécuté sur un ordinateur. De préférence, ce produit programme d'ordinateur prend la forme d'un support lisible par ordinateur sur lequel sont stockées lesdites instructions de code de programme.

## PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :

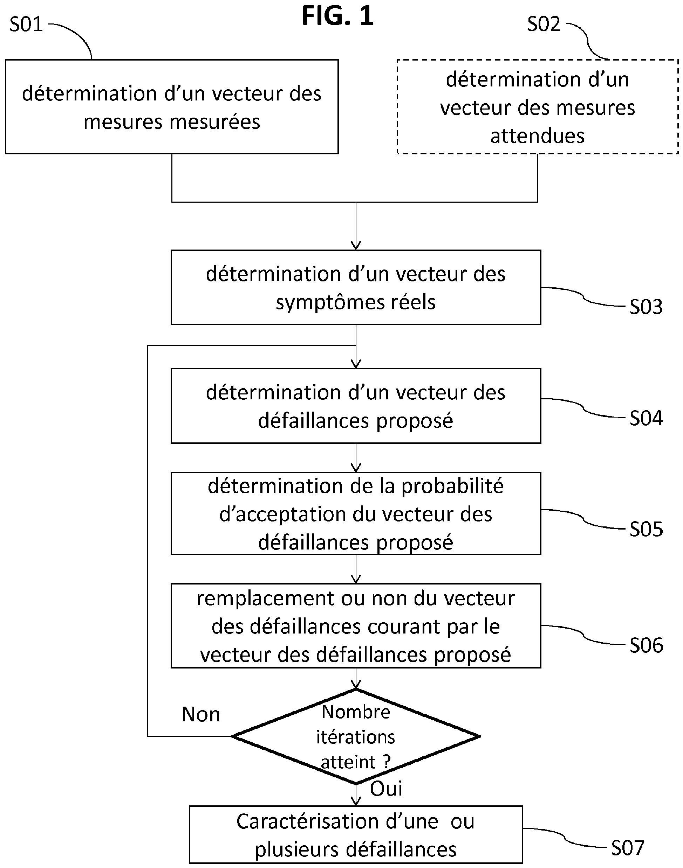

- la figure 1 est un schéma de principe illustrant les principales étapes du procédé de caractérisation ;
- la figure 2 est un schéma illustratif d'un arbre bayésien.

## DESCRIPTION DETAILLEE

Un système regroupe une pluralité de grandeurs physiques internes et est délimité par une pluralité de grandeurs physiques aux limites. L'évolution des grandeurs physiques internes dépend du fonctionnement du système, tandis que l'évolution des grandeurs physiques aux limites ne dépend pas du fonctionnement du système considéré. Ainsi, parmi les grandeurs physiques aux limites on trouve par exemple la température extérieure ou une consigne de fonctionnement pour le système, imposée par un utilisateur externe au système. Les grandeurs physiques aux limites sont ainsi externes au système considéré, et sont donc indépendantes des défaillances de celui-ci.

Le système est instrumenté, c'est-à-dire qu'il est muni d'une pluralité de capteurs mesurant des valeurs de grandeurs physiques internes et des grandeurs physiques externes. De préférence, le système comprend au moins dix capteurs. En effet, l'invention est robuste et particulièrement intéressante en grande dimension. A partir d'une dizaine de capteurs, elle se démarque des méthodes de l'état de la technique travaillant sur la base d'un apprentissage incapable de caractériser efficacement des problèmes complexes faiblement instrumentés.

Pour illustrer et de manière non limitative, l'invention sera par la suite décrite dans le cas où le système dont les défaillances sont à caractériser est une partie d'une centrale nucléaire. L'invention peut être appliquée à d'autres types de systèmes ou installations, et en particulier à toute installation thermique de production électrique (centrale au charbon ou au gaz par exemple).

Le système considéré est constitué par le circuit secondaire d'un réacteur nucléaire. Le circuit secondaire est un circuit fermé de circulation d'un fluide caloporteur recevant au niveau d'un générateur de vapeur de la chaleur en provenance du circuit primaire et fournissant un travail mécanique à un groupe turbo-alternateur produisant de l'électricité.

Un tel circuit secondaire de centrale nucléaire compte plusieurs centaines de capteurs. Toutefois, il n'est pas nécessaire d'exploiter toutes les mesures, et l'invention peut être mise en oeuvre en exploitant moins de capteurs, en sélectionnant les plus pertinents pour rendre compte d'une défaillance. A titre d'exemple, il est possible de mettre en oeuvre le procédé pour un circuit secondaire de centrale nucléaire en exploitant environ 80 capteurs différents, qui produisent ainsi 80 mesures de 80 grandeurs physiques.

Dans cet exemple, les grandeurs physiques aux limites peuvent par exemple être choisies parmi le débit et la température du fluide du circuit primaire entrant dans le générateur de vapeur, la température et le débit de la source froide d'un condenseur, la puissance électrique appelée par le réseau, le débit des purges, etc. Les grandeurs physiques internes sont par exemple les températures, pressions ou débits de fluide caloporteur à différents endroits du circuit secondaire, etc.

Le système est modélisé par un modèle sain établissant des relations liant entres elles des grandeurs physiques internes et avec les grandeurs physiques aux limites en l'absence de défaillance. Chacun des capteurs du système est identifié dans le modèle sain. La modélisation du système est réalisée à partir des composants du système et des équations physiques connues de l'homme du métier. Dans l'exemple de la centrale nucléaire, le modèle sain désigne ainsi la modélisation complète du circuit secondaire en fonctionnement établi et à pleine puissance. Le modèle s'appuie sur des conditions aux limites du circuit secondaire et, en simulation, recalcule les grandeurs physiques internes, qu'on peut qualifier de thermohydrauliques pour le circuit secondaire, pour chaque point de mesure sur le circuit. Lors d'une simulation, le modèle calcule l'état thermohydraulique attendu du système à partir des conditions aux limites. Il calcule en particulier les valeurs attendues pour chaque grandeur physique interne mesurée par un capteur.

*Création de la matrice des défaillances*

Le procédé comprend une étape préalable de création d'une matrice des défaillances $M_{défaillances}$ pour le système. Une défaillance est une avarie matérielle susceptible d'impacter le fonctionnement thermohydraulique du système. Une matrice des défaillances regroupe l'ensemble des signatures de chaque défaillance, et donc des avaries matérielles susceptibles d'impacter le fonctionnement thermohydraulique du système. Pour le circuit secondaire, il peut par exemple s'agir de la perte d'étanchéité d'une vanne, de la rupture d'un tube de réchauffeur, d'une détérioration mécanique des ailettes de la turbine, etc.

Une défaillance se définit ainsi comme une altération des relations liant les grandeurs physiques internes entre elles et avec les grandeurs physiques aux limites par rapport au modèle sain. La création de la matrice des défaillances repose sur la modélisation du système en conditions dégradées. Chaque défaillance prise en compte par le procédé est spécifiquement simulée, et permet de créer un vecteur des mesures simulées symptomatique de la défaillance, qui est utilisé pour construire la matrice.

La matrice des défaillances définit la conséquence d'une pluralité de défaillances possibles listées pour le système sur les grandeurs physiques internes. La matrice des défaillances capitalise pour chaque défaillance embarquée dans le diagnostic, sa signature sur l'ensemble des mesures à disposition. De fait la matrice des défaillances réalise une approximation matricielle du modèle dégradé pour des considérations de temps de calcul. La matrice des défaillances prend la forme d'une matrice mathématique (i.e. un ensemble organisé de données selon plusieurs dimensions).

Le nombre de lignes de la matrice est déterminé par la liste des grandeurs physiques internes du système mesurées par des capteurs disponibles sur le système et prises en compte dans le procédé. Le nombre de défaillances susceptibles d'affecter le système, connues au moins partiellement par l'expertise de l'homme du métier, permet de déterminer le nombre de colonnes de la matrice. Il est à noter qu'il est possible de prévoir des défaillances non encore rencontrées par l'homme du métier, mais listées en tant que possibles réalisations, par exemple en listant toutes les avaries possibles de chaque composant du système (fuite, rupture, encrassement, bouchage, etc.). Cela permet de préparer les diagnostics des systèmes industriels dès leur phase de conception.

Cet aspect matriciel rend le procédé facilement évolutif, puisque la prise en compte d'une grandeur physique interne (par exemple par l'ajout d'un capteur mesurant une grandeur physique interne) se traduit par l'ajout d'une nouvelle ligne à la matrice des défaillances. De même, l'identification d'une nouvelle défaillance se traduit par l'ajout d'une nouvelle colonne.

*Remplissage de la matrice des défaillances par la modélisation*

Chaque colonne de la matrice des défaillances constitue la signature d'une dégradation sur l'ensemble des capteurs, c'est-à-dire l'impact qu'a cette défaillance sur chaque grandeur physique interne mesurée prise en compte, chaque ligne correspondant à une grandeur physique interne mesurée.

On cherche donc la signature de chaque défaillance, dont les impacts sur chaque capteur constituent les composantes de la matrice des défaillances. Il est à noter que les composantes de la matrice ne sont pas nécessairement des coefficients constants.

Les composantes de la matrice des défaillances sont déterminées par simulation d'une modélisation du système en conditions dégradées. A partir du modèle sain, chaque défaillance est implémentée dans le modèle sain en modifiant les paramètres internes du modèle sain, c'est-à-dire en modifiant la traduction dans le modèle des relations liant entre elles lesdites grandeurs physiques internes et avec les grandeurs physiques aux limites, et si besoin en ajoutant des équations adaptées pour prendre en compte la dégradation correspondant à la défaillance. Par exemple, si la conduite du fluide dans une canalisation saine conserve le débit, on a donc une relation de conservation du débit dans la canalisation. En revanche, une fuite dans la canalisation se traduira par une perte du débit de fuite dans la canalisation. Il convient donc de représenter cette défaillance par une modification de l'équation reliant les débits d'entrée et de sortie de la canalisation.

On note Di la défaillance, par exemple une fuite, et di la valeur de cette défaillance, par exemple le débit de la fuite. Il est à noter qu'une même défaillance peut prendre plusieurs valeurs caractérisant son amplitude, comme par exemple plusieurs débits pour une même fuite. Pour chaque défaillance (et éventuellement pour chaque valeur de défaillance) on détermine un vecteur des mesures simulées correspondant au fonctionnement défaillant du système, qu'on compare à un vecteur des mesures simulées correspondant au fonctionnement sain du système.

On dispose ainsi d'une part d'un vecteur des valeurs simulées $V^{simulé}_{mesures,Di=0}$ de l'ensemble des grandeurs physiques internes par simulation préalable du modèle sain à partir des grandeurs physiques aux limites. Un même vecteur des mesures simulées $V^{simulé}_{mesures,Di=0}$ du modèle sain peut être utilisé pour caractériser toutes les défaillances. En effet, le modèle sain du système n'étant pas modifié (sauf modification du système, par exemple en cas de remplacement d'un composant du système par un autre avec d'autres caractéristiques), les valeurs résultant d'une simulation seront les mêmes. Il n'est donc pas nécessaire de refaire la simulation du modèle sain pour caractériser chaque défaillance

D'autre part, à partir du modèle dégradé par la défaillance, on obtient alors par simulation un vecteur des mesures simulées $V^{simulé}_{mesures,Di=di}$ de l'ensemble des grandeurs physiques internes par simulation du modèle dégradé à partir des mêmes grandeurs physiques aux limites.

On approxime la réponse du système à la défaillance comme étant une réponse du modèle sain auquel on ajoute la signature de la défaillance Di à sa valeur di :

$$V^{simulé}_{mesures,Di=di} \cong V^{simulé}_{mesures,Di=0} + \mho_{signature\ Di}(di)$$

avec $\mho_{signature\ Di} : di \rightarrow \mho_{signature\ Di}(di)$ la fonction d'approximation analytique de la signature de la défaillance $D_i$ définie pour toutes les valeurs di de Di.

Pour simplifier, on peut utiliser une approximation linéaire pour caractériser le comportement du système défaillant, ce qui résulte en l'utilisation d'un vecteur signature $V_{signature\ Di}$ à coefficients constants :

$$V^{simulé}_{mesures,Di=di} \cong V^{simulé}_{mesures,Di=0} + di \times V_{signature\ Di}$$

Puisque les vecteurs de valeurs simulées $V^{simulé}_{mesures,Di=0}$ et $V^{simulé}_{mesures,Di=di}$ sont connus par simulation du modèle sain et du modèle dégradé, il est ainsi possible de déterminer la signature de la défaillance, qui peut prendre selon les cas la forme d'un vecteur signature $V_{signature\ Di}$ ou d'une fonction signature $\mho_{signature\ Di} : di \rightarrow \mho_{signature\ Di}(di)$ permettant de déterminer un vecteur signature. Par extension, il est à noter que la fonction $\mho_{signature\ Di}$ peut également être définie sur un espace à plusieurs dimensions, les éléments de cet espace étant des vecteurs représentatifs d'un cumul de défaillances. Cela est intéressant si la coexistence de plusieurs défaillances génère des impacts mutuels sur leurs signatures respectives. Dans la description qui suit, on utilisera pour simplifier un vecteur signature $V_{signature\ Di}$ à coefficients constants.

Dans le cas où la simulation d'un comportement défaillant du modèle n'est pas possible (méconnaissance du phénomène de dégradation, etc.), ou pour consolider une signature issue du modèle numérique de défaillance, il est envisageable de tirer parti de l'archivage des mesures du système lors d'une défaillance passée diagnostiquée rétrospectivement, pour en révéler la signature. Pour ce faire il suffit de comparer les mesures archivées avec les résultats de simulation du modèle sain dans les conditions de survenue de la défaillance.

La matrice des défaillances peut alors être construite puisque chaque colonne de cette matrice des défaillances correspond à un vecteur signature d'une défaillance. Comme indiqué plus haut, la modification du fonctionnement du système sain en présence d'une défaillance est ainsi modélisée grâce à la matrice des défaillances qui définit la conséquence attendue de chaque défaillance listée sur les grandeurs physiques internes.

*Acquisition des mesures du système*

Comme indiqué plus haut, le système est muni d'une pluralité de capteurs mesurant des valeurs de grandeurs physiques internes et des grandeurs physiques externes exigées pour le fonctionnement du modèle sain. Ces capteurs sont utilisés pour relever les mesures d'un ensemble de grandeurs physiques internes.

De préférence, le procédé est appliqué à un système stabilisé dans un état stationnaire ou périodique, qui peut être décrit par des grandeurs indépendantes du temps (ex : fréquence, déphasage, amplitude). Par conséquent, avant d'acquérir les mesures permettant la caractérisation de l'éventuelle défaillance, le fonctionnement du système est stabilisé afin de se prémunir de possibles effets transitoires. Il s'agit de ne pas modifier les paramètres de fonctionnement du système. Dans le cas d'un circuit secondaire d'une centrale nucléaire, il s'agit de garder fixe le niveau de production électrique et de ne pas agir sur les vannes du circuit. Dans ce cas et à titre indicatif, 5 à 10 minutes de stabilisation permettant de disposer de mesures suffisamment stables sont suivies de 20 minutes d'acquisition de mesures par les capteurs.

Pendant le régime stabilisé, les mesures par les capteurs d'un ensemble de grandeurs physiques internes sont relevées. On construit (étape S01) ainsi un vecteur des mesures mesurées $V_{mesures}^{mesuré}$ à partir de ces relevés. De préférence, pour chaque capteur, une pluralité de mesures sont relevées, et leur moyenne est utilisée. Par exemple, des mesures peuvent être relevées périodiquement, par exemple toutes les 2 secondes, pour chaque capteur. La valeur moyenne de ces mesures constitue alors la valeur de la mesure pour ce capteur.

Il est possible de procéder à une validation de chaque mesure relevée pour en détecter les incohérences. Un premier test consiste à vérifier que chaque mesure se trouve dans des bornes cohérentes avec la grandeur physique mesurée par le capteur. On peut ainsi écarter des mesures dont les valeurs sont clairement erronées du fait de capteurs hors-service, comme par exemple une température négative en degré Celsius pour l'eau du circuit secondaire. Selon un autre test, l'écart-type de chaque série temporelle de mesures du même capteur doit être comprise dans des bornes correspondant à un écart-type normal du capteur. On peut ainsi écarter des mesures dont l'évolution trop forte indique un dysfonctionnement du capteur.

On peut alors créer un vecteur booléen en miroir du vecteur des mesures mesurées $V_{mesures}^{mesuré}$ (de même dimension), qui stocke l'information relative au succès des tests : une valeur (e.g. 1) si les tests sont réussis, et une autre valeur (e.g. 0) si les tests ont échoué. On obtient alors un vecteur d'observation des mesures qui indique pour chaque mesure si elle est correcte et doit être prise en compte ou au contraire si elle est fausse et doit être occultée, c'est-à-prise non prise en compte. Une mesure fausse est ainsi conservée dans le vecteur mais non prise en compte dans le procédé (symptômes non observés).

*Vecteur des valeurs attendues*

Le modèle sain est utilisé avec les grandeurs physiques aux limites correspondantes à celles du système lorsque les mesures ont été relevées. Par simulation du modèle sain, on calcule les mesures attendues pour chaque grandeur physique interne mesurée par un capteur, ce qui permet de connaître la valeur attendue de chaque mesure du vecteur des mesures. La simulation permet de déterminer la référence correspondant au fonctionnement sain du système (i.e. en l'absence de défaillance) dans les conditions aux limites auxquelles il est soumis. De fait, chaque simulation est unique. On obtient ainsi (étape S02) un vecteur des mesures attendues $V_{attendues}^{simulé}$, de même dimension que le vecteur des mesures mesurées, qui regroupe les valeurs des grandeurs physiques internes déterminées par simulation pour le modèle sain.

*Vecteur des symptômes réels*

On détermine ensuite le vecteur des symptômes réels (étape S03). Le vecteur des symptômes réels $V_{symptômes}^{réels}$ se définit comme l'écart entre le vecteur des mesures mesurées $V_{mesures}^{mesuré}$ et le vecteur des mesures

attendues $V_{mesures}^{simulé}$ :

$$V_{symptômes}^{réels} = V_{mesures}^{mesuré} - V_{mesures}^{simulé}$$

A partir du vecteur des symptômes réels et du vecteur d'observation des mesures déterminé précédemment, on définit le vecteur des symptômes réels observés, qui se définit comme la réduction du vecteur des symptômes réels aux seules mesures validées $V_{symptômes}^{réels,observés}$.

*Vecteur des défaillances complet*

Le vecteur des défaillances complet se définit comme le vecteur recensant les valeurs de chaque défaillance du système. Il est de la dimension du nombre de défaillances prises en compte dans le procédé. A titre indicatif, pour un circuit secondaire, on peut envisager plusieurs dizaines de défaillances, en raison de la complexité du circuit et de ses nombreux composants. Par convention, si l'on n'a aucune idée de la valeur d'une défaillance (cas le plus fréquent) on renseignera par défaut une valeur nulle dans le vecteur des défaillances complet.

Toutefois, si un ensemble de défaillances affectant le système au moment de mise en oeuvre du procédé est préalablement connu, il est possible pour un opérateur de renseigner leurs valeurs. Dans ce cas, un vecteur des défaillances connues $V_{défaillances}^{connues}$ est créé à partir du vecteur des défaillances complet. Dans la suite du procédé, le vecteur des défaillances connues $V_{défaillances}^{connues}$ vient ainsi compléter la recherche des défaillances recherchées, qui est alors restreinte aux valeurs représentatives des défaillances listées dans la liste des défaillances possibles non comprise dans l'ensemble défini par le vecteur des défaillances connues $V_{défaillances}^{connues}$.

Le vecteur des défaillances connues permet de tirer parti de la connaissance éventuelle d'une défaillance par l'opérateur, et permet donc d'améliorer la caractérisation des autres défaillances puisque cette défaillance connue sera prise en compte comme telle dans le procédé.

*Lois a priori des défaillances*

La densité de probabilité apriori de chaque défaillance est définie comme une loi semi-continue issue de la combinaison :

- D'une loi booléenne représentative de la probabilité de présence de la défaillance,
- D'une loi constante (non-informative) balayant les différentes valeurs de défaillances physiquement admissibles.

*Principe général*

Le principe général de la méthode repose sur l'approximation suivante :

$$V_{symptômes}^{réels} \cong M_{défaillances} \times V_{défaillances}$$

avec $V_{symptômes}^{réels}$ le vecteur des symptômes réels, $M_{défaillances}$ la matrice des défaillances et $V_{défaillances}$ le vecteur des défaillances. La matrice des défaillances est ici un prérequis qui sert d'approximation du modèle du système embarquant l'ensemble des défaillances du procédé. On remarque que la matrice des défaillances peut être facilement utilisée de manière itérative et peut par conséquent se substituer, dans le processus itératif exposé plus loin, à la simulation d'une modélisation du système en conditions dégradées qui prendrait plusieurs secondes à chaque itération. En conséquence, l'utilisation de la matrice des défaillances permet de limiter considérablement les temps de calcul.

Les symptômes sont liés aux défaillances par une relation stochastique causale, c'est-à-dire que les défaillances causent les symptômes. La causalité physique (déterministe) est déterminée par la matrice des défaillances. Pour une combinaison donnée de défaillances, la matrice des défaillances permet de calculer le vecteur des symptômes associés à la combinaison de défaillances.

On déduit à partir de la causalité physique déterministe, caractérisée par la matrice des défaillances, la causalité stochastique qui s'entend comme la combinaison de la causalité déterministe imposée par la physique, ajoutée d'un bruit stochastique dû aux sources d'incertitudes liées à la mesure et à la représentativité du modèle sain et de la matrice des défaillances.

Le renseignement des lois apriori des défaillances inconnnues, des valeurs des défaillances connues, des relations causales probabilistes liant chaque défaillance et cumul de défaillances à leurs symptômes (via la matrice des défaillances) ainsi que l'observation d'un nombre important de symptômes répond aux conditions nécessaires et suffisantes à l'élaboration d'un arbre bayésien dont il conviendra de déterminer la loi jointe.

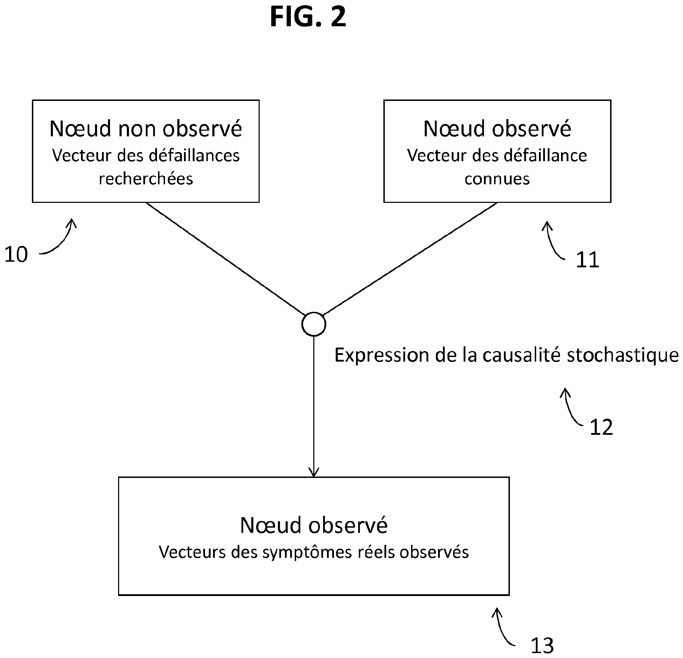

La figure 2 montre un exemple d'un tel arbre bayésien. Un nœud non observé 10 correspond au vecteur des défaillances recherchées, tandis qu'un noeud observé d'origine 11 correspond au vecteur des défaillances connues. L'expression de la causalité stochastique 12 correspond à l'utilisation de la matrice des défaillances et à l'introduction du bruit stochastique lié à la représentativité du modèle sain, de la matrice des défaillances et aux incertitudes de mesure. Le nœud observé résultant 13 correspond au vecteur des symptômes réels observés.

*Loi jointe*

On est en mesure de procéder de manière algorithmique à la construction de la loi jointe de l'arbre bayésien ainsi défini. Les variables aléatoires sont les défaillances recherchées (ie : qui ne sont pas couvertes par le vecteur des défaillances connues). Les observations sont les symptômes réels observés et le vecteur des défaillances connues.

Soit X1, X2, ..., Xn les « n » variables aléatoires que l'on cherche à caractériser et O1,O2, ..., Ok les « k » observations réalisées sur le système. La loi jointe du problème est alors de dimension n :

$$f_{X1,X2,...,Xn|O1,O2,...,Ok}(x_1, x_2, ..., x_n)$$

La connaissance de la loi jointe permet de caractériser pleinement le diagnostic du système.

Il est cependant difficile de construire analytiquement la loi jointe du problème. Toutefois, il est possible de caractériser de manière heuristique la loi jointe recherchée, à l'aide d'un algorithme fonctionnant par tirages successifs de valeurs pour toutes les variables aléatoires du problème, et dont chaque nouveau tirage dépend exclusivement du tirage précédent et du paramétrage du réseau bayésien.

Le procédé est par la suite plus en détail décrit dans le cas de l'algorithme de Metropolis, qui est un exemple d'algorithme de Monte Carlo par Chaines de Markov, qui permet de reproduire des échantillons qui convergent en grandes dimensions vers des échantillons tirés pseudo aléatoirement selon cette loi jointe. En conséquence, avec un nombre suffisamment grand de tirages, l'échantillon produit par l'algorithme de Monte Carlo par Chaines de Markov est représentatif de la loi jointe recherchée. Il est cependant à noter que l'algorithme de Metropolis n'est pas le seul algorithme à permettre de reproduire par tirages successifs un échantillon issu de la loi jointe.

*Itérations*

Pour reconstruire empiriquement la loi jointe, on procède de façon itérative pour un nombre donné d'itérations, qui peut être grand, typiquement supérieur à 10 000 itérations, et par exemple de 100 000 itérations. Chaque itération débute à partir d'un vecteur des défaillances courant $V_{défaillances}^{courant}$, résultant de l'itération précédente, qui regroupe des valeurs représentatives d'une ou plusieurs défaillances. Le vecteur des défaillances courant correspond à une expression du vecteur des variables aléatoires de la loi jointe.

Il est à noter que, si des défaillances affectent le système de façon certaine au moment de la réalisation du procédé, l'opérateur a pu renseigner le vecteur des défaillances connues $V_{défaillances}^{connues}$. Dans ce cas, le vecteur des défaillances courant est complété par le vecteur des défaillances connues par concaténation des composantes des deux vecteurs pour créer le vecteur des défaillances courant complété $V_{défaillances}^{courant,complété}$.

Pour initialiser le processus (première itération), on prend pour vecteur des défaillances courant $V_{défaillances}^{courant}$ un premier vecteur des défaillances supposé être le premier tirage de la loi jointe. Ce premier vecteur des défaillances peut être initialisé à 0 (aucune dégradation) pour les défaillances inconnues.

Lors des itérations, on détermine un vecteur des symptômes courant $V_{symptômes}^{courant}$ à partir du vecteur des défaillances courant complété $V_{défaillances}^{courant\ complété}$ (issu de la concaténation du vecteur des défaillances courant et du vecteur des défaillances connues) en utilisant la matrice des défaillances $M_{défaillances}$. Cette détermination consiste simplement à appliquer la matrice des défaillances $M_{défaillances}$ au vecteur des défaillances courant complété :

$$V^{courant}_{symptômes} = M_{défaillances} \times V^{courant\ complété}_{défaillances}$$

On obtient alors le comportement attendu du système en présence des défaillances dans le vecteur des défaillances courant, éventuellement complété des défaillances connues. Il est à noter que ce vecteur des symptômes courant peut être connu de l'itération précédente où il a été calculé. Il n'est alors pas nécessaire de le recalculer.

Il convient maintenant de définir un vecteur des symptômes observés courant $V^{courant,observés}_{symptômes}$ à partir du vecteur d'observation des mesures défini plus haut et du vecteur des symptômes courant $V^{courant}_{symptômes}$. Le vecteur des symptômes observés courant $V^{courant,observés}_{symptômes}$ est une réduction du vecteur des symptômes courant $V^{courant}_{symptômes}$ aux seules mesures validées. De même que le vecteur des symptômes courant, ce vecteur des symptômes observés courant peut être connu de l'itération précédente où il a été calculé. Il n'est alors pas nécessaire de le recalculer.

On détermine (étape S04) un vecteur des défaillances proposé à partir du vecteur des défaillances courant par un tirage pseudo-aléatoire utilisant une loi de probabilité sur chacune des valeurs des défaillances du vecteur des défaillances courant. La loi de probabilité, de préférence symétrique, est utilisée comme fonction de transition, ou "jumping function" selon la terminologie anglo-saxonne. La fonction de transition est paramétrée de manière cohérente avec les dégradations (variables aléatoires de la loi jointe) de façon à permettre le tirage pseudo-aléatoire des vecteurs de défaillances proposés de proche en proche. A titre d'exemple, la fonction de transition peut prendre la forme d'une distribution gaussienne dont la matrice de covariance est adaptée aux amplitudes des plages de valeurs admissibles de chaque défaillance recherchée.

On propose ainsi par tirage pseudo-aléatoire dans la fonction de transition un vecteur des défaillances proposé $V^{proposé}_{défaillances}$ pour figurer dans l'échantillon qui sera à terme représentatif de la loi jointe.

On détermine alors un vecteur des symptômes proposé $V^{proposé}_{symptômes}$ à partir du vecteur des défaillances proposé complété $V^{proposé\ complété}_{défaillances}$ (issu de la concaténation du vecteur des défaillances proposé $V^{proposé}_{défaillances}$ et du vecteur des défaillances connues $V^{connues}_{défaillances}$) en utilisant la matrice des défaillances $M_{défaillances}$. Cette détermination consiste simplement à appliquer la matrice des défaillances $M_{défaillances}$ au vecteur des défaillances proposé complété :

$$V^{proposé}_{symptômes} = M_{défaillances} \times V^{proposé\ complété}_{défaillances}$$

On obtient alors le comportement attendu du système en présence des défaillances dans le vecteur des défaillances proposé complété. Il convient maintenant de définir le vecteur des symptômes observés proposé $V^{proposé,observés}_{symptômes}$ à partir du vecteur d'observation des symptômes défini plus haut et du vecteur des symptômes proposé $V^{proposé}_{symptômes}$. Le vecteur des symptômes observés proposé $V^{proposé,observés}_{symptômes}$ est une réduction du vecteur des symptômes proposé $V^{proposé}_{symptômes}$ aux seules mesures validées.

On détermine (étape S05) ensuite la probabilité d'acceptation du vecteur des défaillances proposé en comparant la densité de la loi jointe au point du vecteur des défaillances proposé avec la densité de la loi jointe au point du vecteur des défaillances courant. On utilise le vecteur des symptômes réels observés, la matrice des défaillances, le vecteur des défaillances proposé, le vecteur des défaillances courant, la distribution probabiliste du vecteur des symptômes réels sachant le vecteur des défaillances courant complété, la distribution probabiliste du vecteur des symptômes sachant le vecteur des défaillances proposé complété (définies via la matrice des défaillances et la caractérisation probabiliste de la causalité liant chaque symptôme aux défaillances), et la distribution de probabilité apriori de survenues des valeurs du vecteur des défaillances proposé pour déterminer cette probabilité d'acceptation.

À partir du vecteur des symptômes courant (respectivement proposé) et des incertitudes métrologiques, des incertitudes de représentativité des modèles et des incertitudes de représentativité de la matrice de défaillance, on définit la distribution de probabilité du vecteur des symptômes réels sachant le vecteur des défaillances courant complété (respectivement sachant le vecteur des défaillances proposé complété).

Le vecteur des symptômes courant (respectivement proposé) est l'espérance de la distribution probabiliste du vecteur des symptômes réels sachant le vecteur des défaillances courant (respectivement du vecteur des symptômes réels sachant le vecteur des défaillances proposé).

Le vecteur des défaillances courant est alors remplacé ou non par le vecteur des défaillances proposé en fonction de cette comparaison, et plus précisément avec une probabilité égale à la probabilité d'acceptation (étape S06).

*Formalisation mathématique du calcul de la probabilité d'acceptation du vecteur des défaillances proposé*

Pour simplifier la lecture de la formalisation mathématique qui suit, on considérera qu'aucune défaillance n'est connue apriori. En conséquence et dans ce cas particulier, le vecteur des défaillances courant $V_{défaillances}^{courant}$ est strictement égal au vecteur des défaillances courant complété $V_{défaillances}^{courant,complété}$.

La loi jointe du problème ici posé se définit comme la loi de probabilité de la variable aléatoire des défaillances recherchées D, sachant les observations du problème, ici limitées aux seuls symptômes réels (puisque par hypothèse, aucune défaillance n'est connue). On notera S la variable aléatoire des symptômes, observés aux valeurs définies par le vecteur des symptômes réels observés $V_{symptômes}^{réels,observés}$.

$$\forall d, f(D = d | S = V_{symptômes}^{réels,observés})$$

On calcule le rapport de la loi jointe évaluée au vecteur des défaillances proposé $V_{défaillances}^{proposé}$ sur la loi jointe évaluée au vecteur des défaillances courant $V_{défaillances}^{courant}$ et, par définition, sachant le vecteur des symptômes réels observés $V_{symptômes}^{réels,observés}$ :

$$R = \frac{f(D = V_{défaillances}^{proposé} | S = V_{symptômes}^{réels,observés})}{f(D = V_{défaillances}^{courant} | S = V_{symptômes}^{réels,observés})}$$

Remarquons que via le théorème de Bayes :

$$f\left(D = V_{défaillances}^{proposé} \middle| S = V_{symptômes}^{réels,observés}\right)$$
$$= \frac{f\left(S = V_{symptômes}^{réels,observés} \middle| D = V_{défaillances}^{proposé}\right) \times f(D = V_{défaillances}^{proposé})}{f(S = V_{symptômes}^{réels,observés})}$$

Il vient :

$$R = \frac{f\left(D = V_{défaillances}^{proposé} \middle| S = V_{symptômes}^{réels,observés}\right)}{f\left(D = V_{défaillances}^{courant} \middle| S = V_{symptômes}^{réels,observés}\right)}$$

$$R = \frac{f\left(S = V_{symptômes}^{réels,observés} \middle| D = V_{défaillances}^{proposé}\right) \times f(D = V_{défaillances}^{proposé})}{f\left(S = V_{symptômes}^{réels,observés} \middle| D = V_{défaillances}^{courant}\right) \times f(D = V_{défaillances}^{courant})}$$

On reconnaît dans cette expression : $f\left(S = V_{symptômes}^{réels,observés} \middle| D = V_{défaillances}^{proposé}\right)$ : la distribution probabiliste du vecteur des symptômes observés sachant le vecteur des défaillances proposé, évaluée au vecteur des symptômes réels observé. Cette distribution probabiliste est définie à partir du vecteur des défaillances proposé, de la matrice des défaillances et de la caractérisation probabiliste de la causalité liant chaque symptôme aux défaillances.

$f\left(S = V_{symptômes}^{réels, observés} \middle| D = V_{défaillances}^{courant}\right)$ : la distribution probabiliste du vecteur des symptômes réels observés sachant le vecteur des défaillances courant, évaluée au vecteur des symptômes réels observés. Cette distribution probabiliste est définie à partir du vecteur des défaillances courant, de la matrice des défaillances et de la caractérisation probabiliste de la causalité liant chaque symptôme aux défaillances. $f\left(D = V_{défaillances}^{proposé}\right)$ : la valeur au point correspondant au vecteur des défaillances proposé de la distribution de probabilité apriori du vecteur des défaillances ;

$f\left(D = V_{défaillances}^{courant}\right)$ : la valeur au point correspondant au vecteur des défaillances courant de la distribution de probabilité apriori du vecteur des défaillances.

$$P(\text{acceptation}) = \begin{cases} 1 \text{ si R} \geq 1 \\ \text{R si R} < 1 \end{cases}$$

Ainsi, le vecteur des défaillances proposé $V_{défaillances}^{proposé}$ remplace le vecteur des défaillances courant $V_{défaillances}^{courant}$ si R est supérieur ou égal à 1, et le vecteur des défaillances proposé $V_{défaillances}^{proposé}$ a une probabilité R de remplacer le vecteur des défaillances courant $V_{défaillances}^{courant}$ si R est inférieur à 1.

S'il est accepté, le vecteur des défaillances proposé est retenu dans l'échantillon de résultats et remplacera le vecteur des défaillances courant en vue du tirage du prochain vecteur des défaillances proposé. S'il est refusé, le vecteur des défaillances proposé n'est pas retenu, et c'est le vecteur des défaillances courant qui est compté une seconde fois dans l'échantillon de résultats et qui est à nouveau utilisé en tant que vecteur des défaillances courant dans l'itération suivante.

L'algorithme procède de manière heuristique, il s'arrête sur demande sans objectif de convergence, généralement après un nombre déterminé d'itérations. A chaque itération, un nouveau vecteur des défaillances est ajouté à l'échantillon.

*Résultats*

A la suite des itérations, on dispose d'un échantillon final constitué par les vecteurs des défaillances qui ont tour à tour été des vecteurs des défaillances proposés et des vecteurs des défaillances courants. On considère l'échantillon final comme une approximation discrète de la loi jointe recherchée. On peut alors aisément l'interroger pour établir la caractérisation de la défaillance.

Le premier vecteur des défaillances courant peut potentiellement se situer dans une zone de très faible densité de la loi jointe. Dans ce cas, un certain délai de convergence vers des zones présentant une densité plus élevée sera observé. Dans le cas d'un échantillon de résultats très grand, cette trajectoire initiale présente un poids négligeable qui ne perturbe pas la reconstruction de la loi jointe. En pratique cette trajectoire initiale entraîne une surreprésentation de certaines valeurs dans la loi jointe reconstituée. Par conséquent, on peut choisir de ne pas retenir dans l'échantillon final les vecteurs des défaillances avant d'avoir atteint un certain nombre d'itérations, par exemple au moins 1000 ou 10000 itérations.

Il est également possible, pour limiter l'autocorrélation lié aux tirages successifs de proche en proche issus de la fonction de transition (et se rapprocher d'un échantillon tiré pseudo aléatoirement dans la loi jointe), de ne retenir dans l'échantillon final qu'une proportion des vecteurs des défaillances issus des itérations, par exemple moins d'un tirage sur trois, sur cinq, voire un sur dix.

*Exploitation des résultats*

Pour réaliser la caractérisation des défaillances affectant le système, on s'intéresse au dénombrement des tirages de chacune des défaillances dans l'échantillon final. On caractérise (étape S07) ainsi une défaillance en comptabilisant le nombre d'itérations ayant fait intervenir ladite défaillance.

On peut déterminer la probabilité de chaque défaillance, c'est-à-dire la probabilité $P(défaillance_i | symptômes\ réels)$ que cette défaillance i soit effectivement présente dans le système considéré sachant les symptômes réels observés :

$$P\left(défaillance_i \middle| V_{symptômes}^{réels\ observés}\right) = \frac{NB\ tirages_{défaillance\ i}}{NB\ tirages_{totaux}}$$

avec *NB tirages*<sub>défaillance i</sub> le nombre de tirages dans l'échantillon final faisant apparaître la défaillance i (c'est-à-dire le nombre d'occurrences retenues du vecteur des défaillances présentant une valeur non nulle de cette défaillance i lors des itérations), et *NB tirages*<sub>totaux</sub> le nombre total de tirages dans l'échantillon final (c'est-à-dire le nombre d'échantillons retenus).

De façon similaire, on peut également déterminer la probabilité d'une combinaison des défaillances, c'est-à-dire la probabilité que plusieurs défaillances i, j et k soient simultanément présentes dans le système considéré sachant les symptômes réels observés :

$$P\left(défaillance_{i,j,k} \middle| V_{symptômes}^{réels\ observés}\right) = \frac{NB\ tirages_{défaillance\ i,j,k}}{NB\ tirages_{totaux}}$$

avec *NB tirages*<sub>défaillance i,j,k</sub> le nombre de tirages dans l'échantillon final faisant apparaître la défaillance i, la défaillance j et la défaillance k (c'est-à-dire le nombre d'occurrences retenues du vecteur des défaillances présentant des valeurs non nulles associées à ces défaillances i, j, k). Par définition, la probabilité d'une combinaison des défaillances correspond à la probabilité de l'intersection de ces défaillances. Par extension, on peut identifier la probabilité de toute proposition logique portant sur la présence d'une ou plusieurs défaillances.

On peut également quantifier une défaillance, en déterminant la valeur qui lui est associée comme correspondant à la moyenne des valeurs di prises par les vecteurs des défaillances qui font apparaître cette défaillance i dans l'échantillon final, c'est-à-dire les valeurs de di qui sont strictement différentes de 0 :

$$Valeur_{défaillance\ i} = moyenne\ (di \neq 0)$$

*Validation*

Une fois le diagnostic le plus probable identifié, on souhaite s'assurer rétrospectivement que parmi les défaillances embarquées dans la bibliothèque figurent bien celles expliquant les symptômes observés. En effet, par construction, le diagnostic ainsi réalisé est lacunaire puisqu'il n'embarque pas la totalité des défaillances pouvant survenir sur le système. Ainsi, si une défaillance non prévue venait à s'exprimer, le diagnostic serait faux, ou a minima incomplet, puisque une partie des problèmes seulement peut être alors diagnostiquée.

Pour pallier ce problème, le procédé peut comprendre une étape de validation dans laquelle on calcule un critère d'acceptation du diagnostic, pour se prémunir des diagnostics non satisfaisants et identifier la survenue d'un problème non prévu.

Un état du système (c'est-à-dire la caractérisation d'une défaillance ou d'une combinaison de défaillances présentes dans le système) est jugé acceptable si le vecteur des symptômes qui lui est associé (calculé via la matrice des défaillances) est cohérent avec le vecteur des symptômes réels observés.

Pour en juger, on reconstruit un vecteur des symptômes théoriques $V_{symptômes}^{théorique}$ qui correspond à l'expression des défaillances diagnostiquées complété du vecteur des défaillances connues et regroupées dans un vecteur $V_{défaillances}^{diagnostiquées}$ complété au travers de la matrice des défaillances M<sub>défaillances</sub> :

$$V_{symptômes}^{théorique} = M_{défaillances} \times V_{défaillances}^{diagnostiquées\ complété}$$

Ce vecteur des symptômes théorique est alors comparé au vecteur des symptômes réels observés pour décider a posteriori de l'acceptabilité du diagnostic. Le critère d'alerte sera donc dépendant de la distance séparant le vecteur des symptômes théoriques ainsi reconstruit du vecteur des symptômes réel. On peut pour cette comparaison utiliser tout critère de distance, comme les normes les plus courantes (valeur absolue des différences, norme euclidienne, etc.).

Il est possible d'associer au vecteur des symptômes une distribution probabiliste représentative de la capacité de l'homme du métier à en interpréter chaque valeur, ce qui revient à associer à chaque vecteur des symptômes une incertitude. Cette incertitude peut être renseignée sous la forme d'une loi multinomiale, centrée sur le vecteur des symptômes.

Les sources d'incertitudes portées par le vecteur des symptômes font directement échos à celles utilisées pour la caractérisation de la causalité probabiliste liant les symptômes aux défaillances dans le processus bayésien présenté plus haut. Elles sont principalement de plusieurs natures qu'il est préférable de borner :

- erreur propre à la mesure, dite erreur métrologique ;
- erreur de représentativité du modèle sain (obtenue en phase de calage du modèle numérique) ;
- erreur de représentativité de la matrice des défaillances.

Les erreurs ainsi quantifiées permettent de paramétrer une matrice de covariance de la loi de probabilité (e.g. multinormale) utilisée pour caractériser la variabilité du vecteur des symptômes. Il est donc possible de caractériser les intervalles de confiance de la loi de probabilité pour quantifier le critère de validation du diagnostic. On peut notamment considérer que le critère de validation diagnostic correspond à la valeur minimale, notée alpha, telle que le vecteur des symptômes réels observés soit dans l'intervalle de confiance de niveau alpha de la loi multinormale (dans la définition elliptique de l'intervalle de confiance) centrée sur le vecteur des symptômes théorique.

Confronté à un diagnostic non valide, il est possible de s'appuyer sur le vecteur des symptômes réels observés pour réaliser une étude complémentaire et potentiellement identifier une défaillance inconnue jusque-là du diagnostic. Pour enrichir les diagnostics futurs de la recherche de cette nouvelle défaillance, il suffit alors de modifier la matrice des défaillances comme évoqué plus haut pour lui faire prendre en compte cette défaillance une fois celle-ci identifiée par d'autres moyens (par exemple une expertise métier).

L'invention n'est pas limitée au mode de réalisation décrit. Des modifications restent possibles, notamment du point de vue de la constitution des divers éléments sans sortir pour autant du domaine de protection de l'invention.

**Revendications**

1. Procédé de caractérisation d'une ou plusieurs défaillances d'un système regroupant une pluralité de grandeurs physiques internes et délimité par une pluralité de grandeurs physiques aux limites,
le système étant modélisé par un modèle sain établissant des relations liant entres elles lesdites grandeurs physiques internes et avec les grandeurs physiques aux limites en l'absence de défaillance, une défaillance se définissant comme une altération des relations liant lesdites grandeurs physiques internes entre elles et avec les grandeurs physiques aux limites par rapport au modèle sain,
ledit système étant muni d'une pluralité de capteurs mesurant des valeurs de grandeurs physiques internes et les grandeurs physiques externes,
le procédé comprenant la mise en oeuvre d'étapes de :

   • détermination (S01) d'un vecteur des mesures mesurées d'un ensemble de grandeurs physiques internes en relevant des valeurs de grandeurs physiques internes mesurées par les capteurs,
   • détermination (S03) d'un vecteur des symptômes réels par la différence entre le vecteur des mesures mesurées et un vecteur de mesures attendues, ledit vecteur de mesures attendues regroupant des valeurs de grandeurs physiques internes obtenues par simulation du modèle sain à partir des grandeurs physiques aux limites,

   **caractérisé en ce que** le procédé comprend en outre la mise en oeuvre d'étapes de :

   • pour un nombre déterminé d'itérations :

      ◦ détermination (S04) d'un vecteur des défaillances proposé à partir du vecteur des défaillances courant par un tirage pseudo-aléatoire utilisant une loi de probabilité sur chacune des valeurs de défaillance du vecteur des défaillances courant, un vecteur des défaillances regroupant des valeurs représentatives d'une ou plusieurs défaillances ;
      ◦ détermination (S05) de la probabilité d'acceptation du vecteur des défaillances proposé en utilisant le vecteur des symptômes réels, une matrice des défaillances, le vecteur des défaillances courant, la distribution probabiliste du vecteur des symptômes réels sachant le vecteur des défaillances courant, le vecteur des défaillances proposé, la distribution probabiliste du vecteur des symptômes réels sachant le vecteur des défaillances proposé, et une distribution de probabilité a priori de survenues des valeurs du vecteur des défaillances, ladite matrice des défaillances regroupant les conséquences de chaque défaillance sur les grandeurs physiques internes
      ◦ remplacement ou non (S06) du vecteur des défaillances courant par le vecteur des défaillances proposé en fonction de la probabilité d'acceptation du vecteur des défaillances proposé,

• caractérisation (S07) d'une défaillance en comptabilisant le nombre d'itérations ayant fait intervenir ladite défaillance dans un vecteur des défaillances courant.

2. Procédé selon la revendication 1, dans lequel la détermination de la probabilité d'acceptation du vecteur des défaillances proposé utilise de plus un vecteur des symptômes proposé et un vecteur des symptômes courant, le vecteur des symptômes courant étant déterminé partir du vecteur des défaillances courant en utilisant la matrice des défaillances, et le vecteur des symptômes proposé étant déterminé à partir du vecteur des défaillances proposé en utilisant la matrice des défaillances.

3. Procédé selon l'une des revendications précédentes, dans lequel chaque colonne de la matrice des défaillances correspond à un vecteur signature d'au moins une défaillance représentatif de l'impact de ladite défaillance sur des grandeurs physiques internes mesurées par des capteurs, et le nombre de lignes de la matrice est déterminé par le nombre de grandeurs physiques internes mesurées prises en compte et le nombre de colonnes de la matrice est déterminé par le nombre des défaillances prises en compte.

4. Procédé selon la revendication 3, comprenant une étape préalable de détermination de la matrice des défaillances, dans laquelle on détermine pour chaque défaillance :

- un premier vecteur de mesures simulées par simulation du modèle sain à partir des grandeurs physiques aux limites ;
- un second vecteur de mesures simulées par simulation du modèle sain en altérant des relations du modèle sain en fonction de la défaillance avec les mêmes grandeurs physiques aux limites ;

le vecteur signature de la défaillance correspondant à la différence entre le second vecteur et le premier vecteur.

5. Procédé selon l'une quelconque des revendications précédentes, dans lequel un ensemble de défaillances affectant le système sont préalablement connues et renseignées dans un vecteur des défaillances connues, et lors des itérations, le vecteur des défaillances courant est complété par le vecteur des défaillances connues.

6. Procédé selon la revendication 5, dans lequel le vecteur des symptômes courant est déterminé à partir de la matrice des défaillances, du vecteur des défaillances courant et du vecteur des défaillances connues, et le vecteur des symptômes proposé est déterminé à partir de la matrice des défaillances, du vecteur des défaillances proposé et du vecteur des défaillances connues.

7. Procédé selon l'une quelconque des revendications précédentes, dans lequel la caractérisation d'une défaillance comprend la détermination de la probabilité de la présence de la défaillance dans le système et/ou la détermination d'une valeur de cette défaillance.

8. Procédé selon l'une quelconque des revendications précédentes, dans lequel la probabilité d'acceptation du vecteur des défaillances proposé est déterminée en comparant la densité de la loi jointe au point du vecteur des défaillances proposé avec la densité de la loi jointe au point du vecteur des défaillances courant, les densités de la loi jointe aux points susmentionnés étant déterminées par le vecteur des symptômes réels observés, la matrice des défaillances, le vecteur des défaillances proposé, le vecteur des défaillances courant, la distribution probabiliste du vecteur des symptômes réels sachant le vecteur des défaillances courant, la distribution probabiliste du vecteur des symptômes réels sachant le vecteur des défaillances proposé, et la distribution de probabilité apriori de survenues des valeurs du vecteur des défaillances proposé.

9. Produit programme d'ordinateur comprenant des instructions de code de programme pour l'exécution des étapes du procédé selon l'une quelconque des revendications précédentes, lorsque ledit programme est exécuté sur un ordinateur.

**Patentansprüche**

1. Verfahren zur Charakterisierung eines oder mehrerer Fehler eines Systems, das eine Vielzahl von internen physikalischen Größen beinhaltet und durch eine Vielzahl von physikalischen Größen an den Grenzen begrenzt wird, wobei das System durch ein gesundes Modell modelliert wird, das Beziehungen herstellt, die in Abwesenheit von Fehlern die internen physikalischen Größen untereinander und mit den physikalischen Größen an den Grenzen verbinden, wobei sich ein Fehler definiert als Veränderung der Beziehungen, die die internen physikalischen Größen untereinander und mit den physikalischen Größen an den Grenzen verbinden, im Vergleich zum gesunden Modell, wobei das System mit einer Vielzahl von Sensoren ausgestattet ist, die Werte von internen physikalischen Größen und externen physikalischen Größen messen,
wobei das Verfahren die Durchführung der folgenden Schritte umfasst:

• Bestimmen (S01) eines Vektors der gemessenen Messwerte eines Satzes mit internen physikalischen Größen durch das Ablesen der von den Sensoren gemessenen Werte der internen physikalischen Größen,
• Bestimmen (S03) eines Vektors der tatsächlichen Symptome aus der Differenz zwischen dem Vektor der gemessenen Messwerte und einem Vektor der erwarteten Messwerte, wobei der Vektor der erwarteten Messwerte die Werte von internen physikalischen Größen beinhaltet, die durch Simulation des gesunden Modells ausgehend von den physikalischen Größen an den Grenzen erhalten werden,

**dadurch gekennzeichnet, dass** das Verfahren ferner die Durchführung der folgenden Schritte umfasst:

• für eine bestimmte Anzahl von Iterationen:

◦ Bestimmen (S04) eines vorgeschlagenen Vektors der Fehler ausgehend von dem aktuellen Vektor der Fehler durch eine pseudo-zufällige Auswahl, bei der auf jeden der Fehlerwerte des aktuellen Vektors der Fehler eine Wahrscheinlichkeitsverteilung angewendet wird, wobei ein Vektor der Fehler repräsentative Werte eines oder mehrerer Fehler beinhaltet;
◦ Bestimmen (S05) der Wahrscheinlichkeit der Annahme des vorgeschlagenen Vektors der Fehler unter Verwendung des Vektors der tatsächlichen Symptome, einer Matrix der Fehler, des aktuellen Vektors der Fehler, der Wahrscheinlichkeitsverteilung des Vektors der tatsächlichen Symptome unter der Bedingung des aktuellen Vektors der Fehler, des vorgeschlagenen Vektors der Fehler, der Wahrscheinlichkeitsverteilung des Vektors der tatsächlichen Symptome unter der Bedingung des vorgeschlagenen Vektors der Fehler, und einer A-priori-Wahrscheinlichkeitsverteilung des Auftretens der Werte des Vektors der Fehler, wobei die Matrix der Fehler die Auswirkungen jedes Fehlers auf die internen physikalischen Größen beinhaltet;
◦ Ersetzen oder nicht (S06) des aktuellen Vektors der Fehler durch den vorgeschlagenen Vektor der Fehler in Abhängigkeit von der Wahrscheinlichkeit der Annahme des vorgeschlagenen Vektors der Fehler,

• Charakterisieren (S07) eines Fehlers durch die zahlenmäßige Erfassung der Anzahl von Iterationen, die den Fehler in einem aktuellen Vektor der Fehler eintreten ließ.

2. Verfahren nach Anspruch 1, wobei das Bestimmen der Wahrscheinlichkeit der Annahme des vorgeschlagenen Vektors der Fehler zusätzlich einen vorgeschlagenen Vektor der Symptome und einen aktuellen Vektor der Symptome einsetzt, wobei der aktuelle Vektor der Symptome ausgehend von dem aktuellen Vektor der Fehler unter Verwendung der Matrix der Fehler bestimmt wird, und wobei der vorgeschlagene Vektor der Symptome ausgehend von dem vorgeschlagenen Vektor der Fehler unter Verwendung der Matrix der Fehler bestimmt wird.

3. Verfahren nach einem der vorstehenden Ansprüche, wobei jede Spalte der Matrix der Fehler einem Signaturvektor von zumindest einem Fehler entspricht, welcher repräsentativ für die Auswirkung dieses Fehlers auf die internen physikalischen Größen ist, die durch Sensoren gemessen werden, und wobei die Anzahl der Zeilen der Matrix durch die Anzahl der gemessenen internen physikalischen Größen bestimmt wird, die berücksichtigt werden, und die Anzahl der Spalten der Matrix durch die Anzahl der Fehler bestimmt wird, die berücksichtigt werden.

4. Verfahren nach Anspruch 3 mit einem vorherigen Schritt des Bestimmens der Matrix der Fehler, wobei für jeden Fehler bestimmt wird:

- ein erster Vektor der Messwerte, die durch Simulieren des gesunden Modells ausgehend von den physikalischen Größen an den Grenzen simuliert werden;
- ein zweiter Vektor der Messwerte, die durch Simulieren des gesunden Modells simuliert werden, indem Beziehungen des gesunden Modells in Abhängigkeit von dem Fehler mit den gleichen physikalischen Größen an die Grenzen verändert werden;

wobei der Signaturvektor des Fehlers der Differenz zwischen dem zweiten Vektor und dem ersten Vektor entspricht.

**5.** Verfahren nach einem der vorstehenden Ansprüche, wobei ein Satz mit Fehlern, die das System beeinträchtigen, vorher bekannt ist und in einem Vektor der bekannten Fehler übernommen wird, und wobei bei den Iterationen der aktuelle Vektor der Fehler durch den Vektor der bekannten Fehler ergänzt wird.

**6.** Verfahren nach Anspruch 5, wobei der aktuelle Vektor der Symptome ausgehend von der Matrix der Fehler, dem aktuellen Vektor der Fehler und dem Vektor der bekannten Fehler bestimmt wird, und wobei der vorgeschlagene Vektor der Symptome ausgehend von der Matrix der Fehler, dem vorgeschlagenen Vektor der Fehler und dem Vektor der bekannten Fehler bestimmt wird.

**7.** Verfahren nach einem der vorstehenden Ansprüche, wobei das Charakterisieren eines Fehlers das Bestimmen der Wahrscheinlichkeit des Vorliegens des Fehlers in dem System und/oder das Bestimmen eines Wertes dieses Fehlers umfasst.

**8.** Verfahren nach einem der vorstehenden Ansprüche, wobei die Wahrscheinlichkeit der Annahme des vorgeschlagenen Vektors der Fehler durch den Vergleich der Dichte der multivariaten Verteilung am Punkt des vorgeschlagenen Vektors mit der Dichte der multivariaten Verteilung am Punkt des aktuellen Vektors der Fehler bestimmt wird, wobei die Dichten der multivariaten Verteilung an den oben genannten Punkten durch den Vektor der tatsächlichen beobachteten Symptome, die Matrix der Fehler, den vorgeschlagenen Vektor der Fehler, den aktuellen Vektor der Fehler, die Wahrscheinlichkeitsverteilung des Vektors der tatsächlichen Symptome unter der Bedingung des aktuellen Vektors der Fehler, die Wahrscheinlichkeitsverteilung des Vektors der tatsächlichen Symptome unter der Bedingung des vorgeschlagenen Vektors der Fehler und die A-priori-Wahrscheinlichkeitsverteilung des Auftretens der Werte des vorgeschlagenen Vektors der Fehler bestimmt werden.

**9.** Computerprogrammprodukt mit Programmcodebefehlen für die Ausführung der Schritte des Verfahrens nach einem der vorstehenden Ansprüche, wenn dieses Programm auf einem Computer ausgeführt wird.

**Claims**

**1.** Method for characterising one or more faults in a system grouping together a plurality of internal physical quantities and delimited by a plurality of boundary physical quantities,
the system being modelled by a healthy model establishing relationships linking said internal physical quantities with one another and with the boundary physical quantities in the absence of a fault, a fault being defined as a negative change in the relationships linking said internal physical quantities with one another and with the boundary physical quantities with respect to the healthy model,
said system being provided with a plurality of sensors measuring values of internal physical quantities and external physical quantities,
the method comprising the implementation of the steps of:

- determination (S01) of a vector of the measured measurements of a set of internal physical quantities by reading the values of internal physical quantities measured by the sensors,
- determination (S03) of a vector of actual symptoms by the difference between the vector of measured measurements and a vector of expected measurements, said vector of expected measurements grouping together values of internal physical quantities obtained by simulation of the healthy model from the boundary physical quantities,

**characterised in that** the method further includes the implementation of the steps of:

- for a determined number of iterations:

  ∘ determination (S04) of a proposed vector of faults from the current vector of faults by a pseudo-random sampling using a probability law on each of the fault values of the current vector of faults, a vector of faults grouping together values representative of one or more faults;
  ∘ determination (S05) of the probability of acceptance of the proposed vector of faults using the vector of actual symptoms, a fault matrix, the current vector of faults, the probabilistic distribution of the vector of actual symptoms knowing the current vector of faults, the proposed vector of faults, the probabilistic distribution of the vector of actual symptoms knowing the proposed vector of faults, and an a priori probability distribution of occurrences of the values of the fault vector, said fault matrix grouping together the consequences of each fault on the internal physical quantities
◦ replacement or not (S06) of the current vector of faults by the proposed vector of faults as a function of the probability of acceptance of the proposed vector of faults,

• characterisation (S07) of a fault by recording the number of iterations having involved said fault in a current vector of faults.

2. Method according to claim 1, wherein the determination of the probability of acceptance of the proposed vector of faults uses in addition a proposed vector of symptoms and a current vector of symptoms, the current vector of symptoms being determined from the current vector of faults using the fault matrix, and the proposed vector of symptoms being determined from the proposed vector of faults using the fault matrix.

3. Method according to one of the preceding claims, wherein each column of the fault matrix corresponds to a signature vector of at least one fault representative of the impact of said fault on internal physical quantities measured by sensors, and the number of lines of the matrix is determined by the number of measured internal physical quantities taken into account and the number of columns of the matrix is determined by the number of faults taken into account.

4. Method according to claim 3, comprising a prior step of determination of the fault matrix, in which is determined for each fault:

   - a first vector of simulated measurements by simulation of the healthy model from the boundary physical quantities;
   - a second vector of simulated measurements by simulation of the healthy model by altering the relationships of the healthy model as a function of the fault with the same boundary physical quantities;

   the signature vector of the fault corresponding to the difference between the second vector and the first vector.

5. Method according to any of the preceding claims, wherein a set of faults affecting the system are known beforehand and entered into a vector of known faults, and during the iterations, the current vector of faults is completed by the vector of known faults.

6. Method according to claim 5, wherein the current vector of symptoms is determined from the fault matrix, the current vector of faults and the vector of known faults, and the proposed vector of symptoms is determined from the fault matrix, the proposed vector of faults and the vector of known faults.

7. Method according to any of the preceding claims, wherein the characterization of a fault includes the determination of the probability of the presence of the fault in the system and/or the determination of a value of this fault.

8. Method according to any of the preceding claims, wherein the probability of acceptance of the proposed vector of faults is determined by comparing the density of the joint law at the point of the proposed vector of faults with the density of the joint law at the point of the current vector of faults, the densities of the joint law at the aforementioned points being determined by the vector of actual observed symptoms, the fault matrix, the proposed vector of faults, the current vector of faults, the probabilistic distribution of the vector of actual symptoms knowing the current vector of faults, the probabilistic distribution of the vector of actual symptoms knowing the proposed vector of faults, and the a priori probability distribution of occurrences of the values of the proposed vector of faults.

9. Computer programme product comprising programme code instructions for the execution of the steps of the method according to any of the preceding claims, when said programme is executed on a computer.

# FIG. 1

S01 — détermination d'un vecteur des mesures mesurées

S02 — détermination d'un vecteur des mesures attendues

détermination d'un vecteur des symptômes réels — S03

détermination d'un vecteur des défaillances proposé — S04

détermination de la probabilité d'acceptation du vecteur des défaillances proposé — S05

remplacement ou non du vecteur des défaillances courant par le vecteur des défaillances proposé — S06

Non — Nombre itérations atteint ?

Oui

Caractérisation d'une ou plusieurs défaillances — S07

# FIG. 2

Nœud non observé
Vecteur des défaillances
recherchées

10

Nœud observé
Vecteur des défaillance
connues

11

Expression de la causalité stochastique

12

Nœud observé
Vecteurs des symptômes réels observés

13

## RÉFÉRENCES CITÉES DANS LA DESCRIPTION

**Documents brevets cités dans la description**

- EP 1677172 A2